# EUROPEAN PATENT APPLICATION

(11) **EP 2 014 797 A2**
(43) Date of publication of application: **14.01.2009**
(21) Application number: 08252007.3
(22) Date of filing: 11.06.2008
(51) Int. Cl.: C23F 11/02, C07F 7/08, H05K 3/36, H01J 17/49, H01J 17/34

(54) **Coating composition for interconnection part of electrode and plasma display panel including the same**

(30) Priority: 11.06.2007 KR 20070056750
(71) Applicant: Samsung SDI Co., Ltd., Suwon-si, Gyeonggi-do (KR)
(72) Inventor: Kim, Chul-Hong, Suwon-si Gyeonggi-do (KR)
(74) Representative: Mounteney, Simon James

(57) **Abstract**

Provided are a coating composition for an interconnection part of an electrode and a plasma display panel including the same. Specifically, the coating composition for an interconnection part of an electrode, comprising 0.05 to 2.0 parts by weight of a compound containing a triazole group, 3.5 to 7.5 parts by weight of a silane based compound, and 0.5 to 2.0 parts by weight of a transition metal oxide, is used to effectively prevent opens and short circuits of an electrode due to damage of an interconnection unit caused by gases and humidity in the surrounding environment and due to a migration phenomenon.

## Description

### BACKGROUND OF THE INVENTION

### 1. Field of the Invention

The present invention relates to a coating composition for an interconnection part of an electrode and a plasma display panel including the same, and more particularly, to a coating composition for an interconnection part of an electrode which effectively prevents damage of the interconnection part due to gases and humidity in the surrounding environment and opens and short circuits of an electrode due to a migration phenomenon, and a plasma display panel including the same.

### 2. Description of the Related Art

Plasma display panels (PDPs) display images using a gas discharge, can be manufactured to be a thin large screen, and produce high-quality images at wide viewing angles. Due to these advantages, plasma display panels are becoming increasingly widely used.

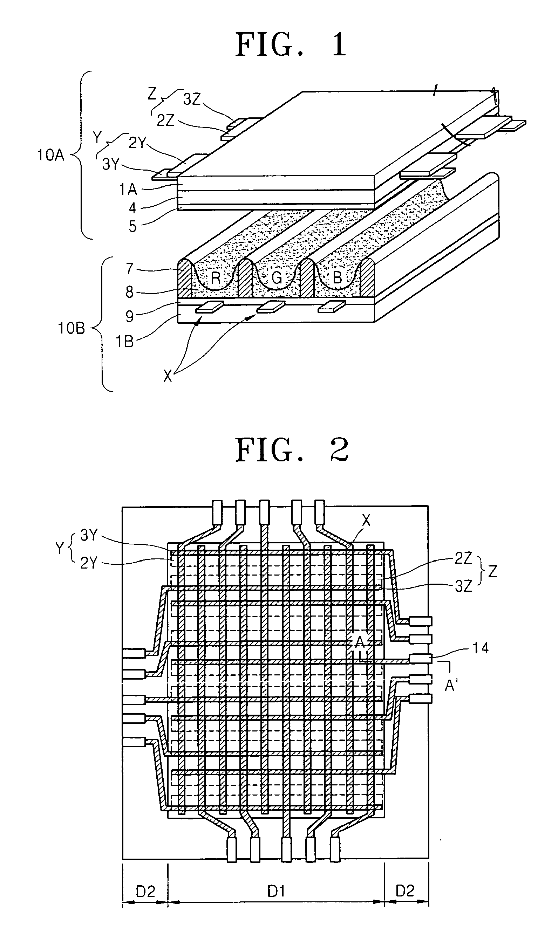

FIG. 1 is a view of a conventional plasma display panel. Referring to FIG. 1, the conventional plasma display panel includes a top panel 10A and a bottom panel 10B combined to and disposed parallel to the top panel 10A. The top panel 10A includes a plurality of display electrodes, each including a pair of a scan electrode Y and a sustain electrode Z on a top glass layer 1A in which images are displayed, and the bottom panel 10B includes a plurality of address electrodes X disposed perpendicular to the sustain electrodes in a bottom glass layer 1B.

The top panel 10A includes a plurality of pairs of the scan electrodes Y to cause a discharge in a single cell and the sustain electrodes Z to sustain the discharge in the cell, wherein each of the scan electrodes Y and the sustain electrodes Z includes a transparent electrode (2Y, 2Z: 2) formed of a transparent ITO and a bus electrode (3Y, 3Z: 3) formed of metal. The scan electrodes Y and the sustain electrodes Z are covered by an upper dielectric layer 4 that limits a discharged current and insulates electrodes from each other. A protecting layer 5 formed of MgO is formed on the upper dielectric layer 4 to facilitate the discharge.

In the bottom panel 10B, a plurality of discharge cells defined by barrier ribs 7 are formed parallel to each other and a discharge gas is filled in the discharge cells. The address electrodes X are disposed parallel to the barrier ribs 7. When a voltage is applied to the address electrodes X, an address discharge is generated in the discharge cells, thus stimulating ultraviolet light to be generated from the discharge gas. The ultraviolet light stimulates R, G, and B phosphor layers 8 formed on sidewalls of the barrier ribs 7 and the bottom glass layer 1B to emit visible light to display images during the address discharge. A lower dielectric layer 9 is formed between the address electrodes X and the R, G and B phosphor layers 8 to protect the address electrodes X.

A conventional plasma display panel having the structure described may further include a frame including a scan and sustain driving unit and an address driving unit, and an interconnection unit providing a predetermined signal from each of the scan and sustain driving unit and the address driving unit to a plasma display panel on its bottom surface.

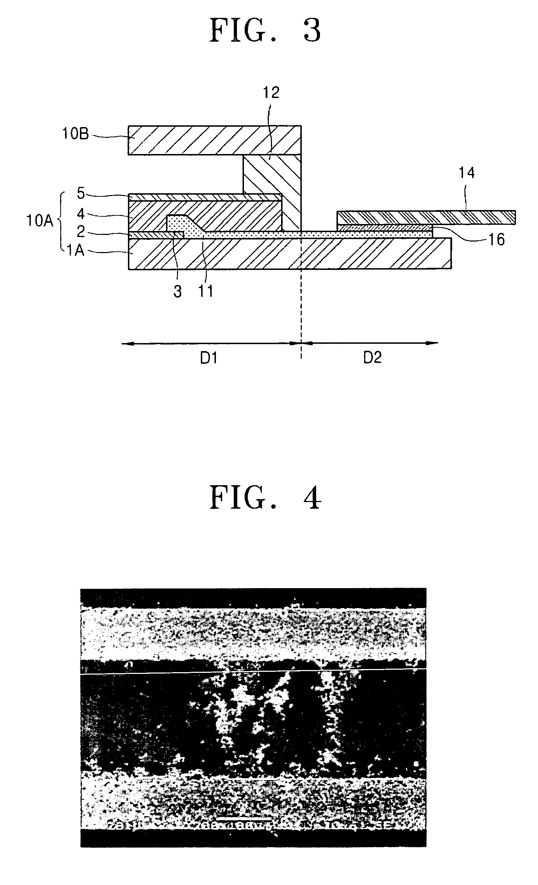

FIG. 2 is a top plan view of a conventional plasma display panel. FIG. 3 is a sectional view of the conventional plasma display panel of FIG. 2 taken along a line A-A' of FIG. 2. Referring to FIGS. 2 and 3, the conventional plasma display panel includes a panel display unit D1, which is a plasma display panel, and a panel interconnection unit D2.

First, the panel display unit D1 has the same structure as described with reference to FIG. 1. That is, the panel display unit D1 includes a top panel 10A, a bottom panel 10B, and a sealing material 12 which seals the top panel 10A and bottom panel 10B to form a discharge cell. The top panel 10A includes transparent electrodes 2Y and 2Z constituting a scan electrode or a sustain electrode parallel to the scan electrode on a top glass layer 1A, metal bus electrodes 3Y and 3Z formed on the ends of the transparent electrodes 2Y and 2Z, respectively, a metal bus electrode pad 11 extending from the metal bus electrodes 3Y and 3Z to the panel interconnection unit D2, and an upper dielectric layer 4 and a protecting layer 5, which cover the transparent electrodes 2Y and 2Z, the metal bus electrodes 3Y and 3Z and the metal bus electrode pad 11 and are sequentially deposited on the top glass layer 1A. The bottom panel 10B includes address electrodes X disposed perpendicular to the transparent electrodes 2Y and 2Z on a bottom glass layer 1 B (not shown), and a lower dielectric layer (not shown) covering the address electrodes X on the bottom glass layer 1 B (not shown).

The panel interconnection unit D2 includes the metal bus electrode pad 11 extending from the panel display unit D1 on the top glass layer 1A, and a film-shaped device 14 which is connected to the metal bus electrode pad 11 and thus supplies a driving signal which is controlled by a printed circuit board (PCB). The metal bus electrode pad 11 is adhered to the film-shaped device 14 by an anisotropic conductive film (ACF) 16. The ACF 16 has a film shape prepared by dispersing conductive particles, such as metal-coated epoxy or metal particles, and electrically connects the metal bus electrode 3 to the film-shaped device 14.

In conventional plasma display panels, electrodes are generally formed of photosensitive silver subjected to a printing-drying-exposing-developing-sintering process, since silver is relatively inexpensive compared to other precious metals and has high conductivity. However, silver can cause opens or short circuits in electrodes because it actively diffuses and migrates.

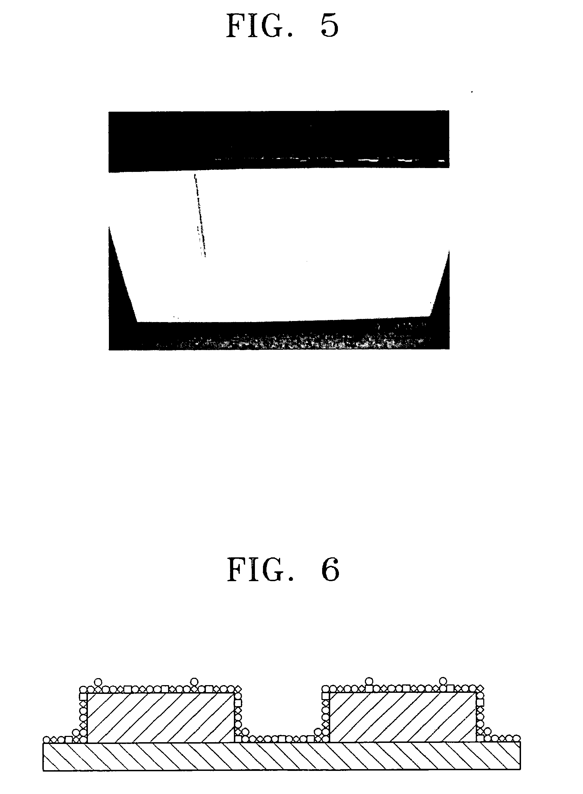

FIG. 4 is a photographic image showing short circuits between electrodes due to diffusion caused by migration of Ag. In particular, such migration of Ag may cause vertical line defects in display units as shown in FIG. 5. A display unit having such vertical line defects cannot be repaired. As a result, a plasma display panel having such vertical line defects has low reliability and low producibility.

### SUMMARY OF THE INVENTION

The present invention provides a coating composition for an interconnection part of an electrode, which effectively prevents opens and short circuits of an electrode due to damage of the interconnection unit due to gases and humidity in the surrounding environment and due to a migration phenomenon, and a plasma display panel including the coating composition.

The present invention also provides a plasma display panel including the coating composition for an interconnection part of an electrode, having excellent reliability and producibility.

According to an aspect of the present invention, there is provided a coating composition for an interconnection part of an electrode, including 0.05-2.0 parts by weight of a compound containing a triazole group, 3.5-7.5 parts by weight of a silane-based compound, and 0.5-2.0 parts by weight of a transition metal oxide.

According to another aspect of the present invention, there is provided a plasma display panel comprising a panel display unit which includes a plurality of electrodes and a panel interconnection unit providing a driving signal to the electrodes, the panel interconnection unit including: electrode pads connected to the electrodes of the panel display unit; the coating composition for an interconnection part of an electrode including 0.05-2.0 parts by weight of a compound containing a triazole group, 3.5-7.5 parts by weight of a silane-based compound, and 0.5-2.0 parts by weight of a transition metal oxide, which is coated on the electrode pads; and a film-shape device connected to the electrode pads.

According to another aspect of the present invention, there is provided a plasma display panel comprising: a first substrate; a second substrate facing the first substrate, with a plurality of discharge cells filled with a discharge gas between the first substrate and the second substrate; a plurality of display electrodes formed on the first substrate opposing to the second substrate, each of said plurality of display electrodes comprising a pair of a transparent electrode formed on the first substrate and a bus electrode formed on a surface of the transparent electrode; bus electrode pads extending from the bus electrodes to the outside of the discharge cells, the bus-electrode pads coated with a coating composition comprising 0.05 to 2.0 parts by weight of a compound containing a triazole group, 3.5 to 7.5 parts by weight of a silane-based compound, and 0.5-2.0 parts by weight of a transition metal oxide, based on 100 parts by weight of the coating composition; and the film-shaped device connected to the bus electrode pad to provide a driving signal.

According to a first aspect of the invention there is provided a coating composition as set out in Claim 1. Preferred features of this aspect are set out in Claims 1 to 9.

According to a second aspect of the invention there is provided a plasma display panel as set out in Claim 10. Preferred features of this aspect are set out in Claims 11 and 12. A further aspect of the invention is provided as set out in Claim 13. Preferred features of this aspect are set out in Claims 14 and 15.

### BRIEF DESCRIPTION OF THE DRAWINGS

The above and other features and advantages of the present invention will become more apparent by describing in detail exemplary embodiments thereof with reference to the attached drawings in which:

FIG. 1 is a perspective view of a conventional plasma display panel (PDP);

FIG. 2 is a top plan view of a conventional plasma display panel;

FIG. 3 is a sectional view of the plasma display panel of FIG. 2 taken along a line A-A' of FIG. 2;

FIG. 4 is a photographic image showing short circuits between electrodes due to diffusion caused by migration of Ag;

FIG. 5 is a photographic image showing a vertical line defect in a plasma display panel;

FIG. 6 is a schematic, sectional view of an interconnection unit which is coated with a coating composition for an interconnection part of an electrode according to an embodiment of the present invention;

FIG. 7 is a sectional view of a plasma display panel including an interconnection unit according to an embodiment of the present invention;

FIG. 8A is a scanning electron microscopic (SEM) image of an interconnection unit on which a coating composition for an interconnection part of an electrode according to an embodiment of the present invention is not coated;

FIG. 8B is a SEM image of an interconnection unit on which a coating composition for an interconnection part of an electrode according to an embodiment of the present invention is coated;

FIG. 9 is a schematic view illustrating conditions for a high temperature/high humidity credibility test performed to identify properties of a coating composition for an interconnection part of an electrode according to the present invention; and

FIGS. 10A to 10D are graphs illustrating results of a data normality test and a test for equal variances performed using a coating composition for an interconnection part of an electrode according to an embodiment of the present invention.

### DETAILED DESCRIPTION OF THE INVENTION

The present invention will now be described more fully with reference to the accompanying drawings, in which exemplary embodiments of the invention are shown.

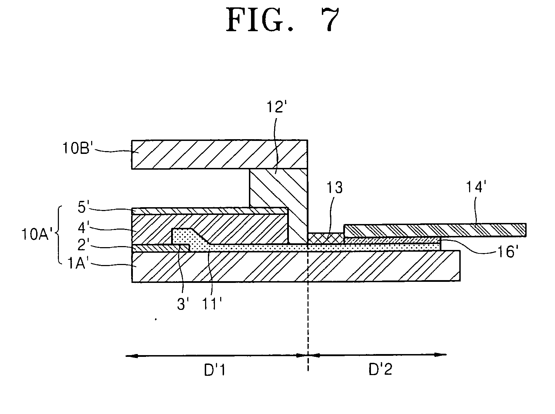

In the specification and claims, the term "interconnection unit" means a panel interconnection unit (e.g., as shown as D'2 in FIG. 7), and the term "interconnection part of an electrode" means a part, which is positioned in the panel interconnection unit, of an electrode.

A coating composition for an interconnection part of an electrode according to an embodiment of the present invention includes 0.05-2.0 parts by weight of a compound containing a triazole group, 3.5-7.5 parts by weight of a silane-based compound, and 0.5-2.0 parts by weight of transition metal oxide.

FIG. 6 is a schematic, sectional view of an interconnection unit which is coated with a coating composition for an interconnection part of an electrode according to an embodiment of the present invention.

Referring to FIG. 6, the coating composition for an interconnection part of an electrode according to the current embodiment of the present invention is coated to a predetermined thickness on an electrode pad formed on a glass substrate. The coating composition for an interconnection part of an electrode according to the current embodiment of the present invention prevents external micro moisture or gas from coming into direct contact with an electrode.

In the coating composition for an interconnection part of an electrode according to the current embodiment of the present invention, the silane-based compound facilitates adhesion of the coating composition to at least one of the substrate and the electrode pad.

In particular, the silane-based compound can be an alkoxy siloxane, dimethyl siloxane, methyltrimethoxy silane, or a blend thereof. More particularly the silane-based compound can have a structure of Formula 1.

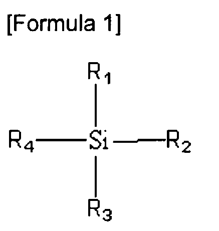

In Formula 1, R_{1'} R₂, R₃ and R₄ are each independently one of H, an alkyl group, a vinyl group, a silane group, an alkylhalide group, a halide group, an aryl group, an alkoxy group, an ether group (alkoxyalkyl group), an epoxide group, an alcohol group, an ester group, an amine group an acid group, a nitrile group and an isocyanate group.

In Formula 1, the silane-based compound can be aliphatic or aromatic and may have a boiling point of 150°C or greater so that it does not vaporize when it is used to prepare a composition. When the silane-based compound is a solid, the silane-based compound should be dissolved in an organic vehicle component. When the silane-based compound is a liquid, the silane-based compound is homogeneously mixed with an organic vehicle to prevent phase separation, and should not cause any change in properties of the composition due to denaturalization of the silane-based compound in the composition.
The silane-based compound can be a compound represented by Formula 1 where at least one functional group selected from R₁, R₂, R₃ and R₄ is -H, an alkyl group, or a vinyl group, and such a compound can be tripropylsilane, triisopropylsilane, tributylsilane, triisobutylsilane, trihexylsilane, dimethyloctadecylsilane, tetraethylsilane, or diisopropyloctylsilane. The silane-based compound can also be triethylvinylsilane, allyltrimethylsilane, allyltriisopropylsilane, trimethyl(3-methyl-2-butyl)-silane, diallyldimethylsilane, tetravinylsilane, tetraallylsilane, triphenylvinylsilane, or allyltriphenylsilane. The silane-based compound can also be a compound represented by Formula 1 where at least one functional group selected from R₁, R₂, R₃ and R₄ is a silane group and such a compound can be bis(trimethylsilyl)methane, tris(trimethylsilyl)methane, hexamethyldisilane, or tetrakis(trimethylsilyl)silane. The silane-based compound can also be a compound represented by Formula 1 where at least one functional group selected from R₁, R₂, R₃ and R₄ is an alkylhalide group or halide group and such a compound can be bis(chloromethyl)dimethylsilane, chlorodiisopropylsilane, 1,2-bis(chlorodimethylsilyl)ethane, chlorotriethylsilane, or chlorodimethyloctylsilane. The silane-based compound can also be a compound represented by Formula 1 where at least one functional group selected from R₁, R₂, R₃ and R₄ is an aryl group and such a compound can be dimethylphenylsilane, 1,2-bis(dimethylsilyl)benzene, 1,4-bis(dimethylsilyl)benzene, phenyltrimethylsilane, diphenylsilane, diphenylmethylsilane, triphenylsilane, tribenzylsilane, benzyltrimethylsilane, or benzyloxytrimethylsilane. The silane-based compound can also be a compound represented by Formula 1 where at least one functional group selected from R₁, R₂, R₃ and R₄ is an alkoxy group or ether group and such a compound can be (methoxymethyl)trimethylsilane, ethoxytrimethylsilane, propoxytrimethylsilane, methoxydimethyloctylsilane, methoxydimethyloctadecylsilane, dimethoxymethyloctylsilane, trimethoxypropylsilane, isobutyltrimethoxysilane, octyltrimethoxysilane, octadecyltrimethoxysilane, methyltrimethoxysilane, ethyltrimethoxysilane, isobutyltriethoxysilane, octyltriethoxysilane, diethoxyphenylsilane, phenyltrimethoxysilane, phenyltriethoxysilane, vinyltrimethoxysilane, triethoxyvinylsilane, allyltriethoxysilane, or tris(2-methoxyethoxy)vinylsilane. The silane-based compound can also be a compound represented by Formula 1 where at least one functional group selected from R_{1'} R₂, R₃ and R₄ is an epoxide group and such a compound can be 3-glycidoxypropyltrimethoxysilane, diethoxy(3-glycidyloxypropyl)methylsilane, or trimethoxy[2-(7-oxabicyclo[4.1.0]hept-3-yl)ethyl]silane. The silane-based compound can also be a compound represented by Formula 1 where at least one functional group selected from R₁, R₂, R₃ and R₄ is an alcohol group and such a compound can be (trimethylsilyl)methanol, 1-(trimethylsilyl)ethanol, 2-(trimethylsilyl)ethanol, 3-(trimethylsilyl)-1-propanoltriethylsilanol, t-butyldimethylsilanol, 5-(t-butyldimethylsilyloxy)-1-pentanol, or 2-(methyldiphenylsilyl)ethanol. The silane-based compound can also be a compound represented by Formula 1 where at least one functional group selected from R₁, R₂, R₃ and R₄ is an ester group and such a compound can be trimethylsilylacetate, trimethylsilylmethylacetate, methyl(trimethylsilyl)acetate, ethyl(trimethylsilyl)acetate, t-butyl(trimethylsilyl)acetate, ethyl 3-(trimethylsilyl)-propionate, 2-[(trimethylsilyl)methyl]-2-propen-1-yl acetate, trimethylsilyl methacrylate, 2-(trimethylsilyloxy)ethyl methacrylate, 3-(trimethoxysilyl)propyl methacrylate, methyltrimethylsilylmalonate, ethyltrimethylsilylmalonate, or bis(trimethylsilyl)malonate. The silane-based compound can also be a compound represented by Formula 1 where at least one functional group selected from R₁, R₂, R₃ and R₄ is an amine group and such a compound can be N,N-diethyl(trimethylsilylmethyl)amine, N-t-butyltrimethylsilylamine, N,N-diethyltrimethylsilylamine, 1,1'-ethylenebis(N,N,1,1-tetramethyl)silaneamine, 1-(trimethylsilyl)pyrrolidine, or 4-(trimethylsilyl)morpholine. The silane-based compound can also be a compound represented by Formula 1 where at least one functional group selected from R₁, R₂, R₃ and R₄ is an acid group and such a compound can be (trimethylsilyl)acetic acid, or 3-(trimethylsilyl)propionic acid. The silane-based compound can also be a compound represented by Formula 1 where at least one functional group selected from R₁, R₂, R₃ and R₄ is a nitrile group and such a compound can be 3-(triethoxysilyl)propionitrile, or t-butyldiphenylsilylcyanide. The silane-based compound can also be a compound represented by Formula 1 where at least one functional group selected from R₁, R₂, R₃ and R₄ is an isocyanate group and such a compound can be 3-(triethoxysilyl)propyl isocyanate. These compounds described above can be used alone or in combination.

However, the silane-based compound is not limited thereto. That is, the silane-based compound included in the coating composition for an interconnection part of an electrode according to the current embodiment of the present invention can be at least one of any silane compound and a siloxane compound, which can be used as an adhesive or sealant in an electronic device by those of ordinary skill in the art.

The amount of the silane-based compound may be in the range of 3.5-7.5 parts by weight based on 100 parts by weight of the coating composition for an interconnection part of an electrode according to the current embodiment of the present invention. When the amount of the silane-based compound is less than 3.5 parts by weight based on 100 parts by weight of the coating composition for an interconnection part of an electrode, the coating composition may be less adhesive to the substrate or electrode interconnection unit and it is impossible to perform an oleophilic treatment on the substrate. On the other hand, when the amount of the silane-based compound is greater than 7.5 parts by weight based on 100 parts by weight of the coating composition for an interconnection part of an electrode, the composition ratio of other constituent compounds of the coating composition for an interconnection part of an electrode according to the current embodiment of the present invention may be changed.

The transition metal oxide included in the coating composition for an interconnection part of an electrode according to the current embodiment of the present invention may act as a filler used to increase hardness and density. For example, the transition metal oxide can be a mineral form of titanium oxide such as rutile, anatase or brookite.

The amount of the transition metal oxide may be in the range of 0.5-2.0 parts by weight based on 100 parts by weight of the coating composition for an interconnection part of an electrode. When the amount of the transition metal oxide is less than 0.5 parts by weight based on 100 parts by weight of the coating composition for an interconnection part of an electrode, no filler effects occur. On the other hand, when the amount of the transition metal oxide is greater than 2.0 parts by weight based on 100 parts by weight of the coating composition for an interconnection part of an electrode, the composition ratio of other constituent compounds of the coating composition for an interconnection part of an electrode according to the current embodiment of the present invention may be changed.

In addition, the coating composition for an interconnection part of an electrode according to the current embodiment of the present invention includes the compound containing a triazole group. The compound containing a triazole group has an anti-migration property. The compound containing a triazole group can be 1,2,3,-triazole, 1,2,4-triazole, benzo triazole, or the like, but is not limited thereto. For example, the compound containing a triazole group can be any compound containing a triazole group having an anti-migration property.

In particular, the compound containing a triazole group having an anti-migration property may be 1-aminobenzotriazole, 3-amino-1,2,4-triazole-5-thiol, 3-amino-1,2,4-triazole, 4-amino-4H-1,2,4-triazole, 1-hydroxybenzotriazole, 1H-1,2,4-triazole-3-thiol, 1H-benzotriazole, 1-(benzyloxycarbonyl)benzotriazole, 3-amino-5-mercapto-1,2,4-triazole, 5-anilino-1,2,3,4-thiatriazole, 3-amino-5-methylthio-1 H-1,2,4-triazole, 5-methyl-1 H-benzotriazole, 1,1'-carbonyl-di-(1,2,4-triazole), 1-(2-mesitylenesulfonyl)-1,2,4-triazole, 1-(2-mesitylenesulfonyl)-3-nitro-1,2,4-triazole, 3-nitro-1,2,4-triazole, 4-methyl-4H-1,2,4-triazole-3-thiol, 1,2,3-triazole-4,5-dicarboxylic acid, 3-nitro-1-(8-quinolylsulfonyl)-1H-1,2,4-triazole, benzotriazole-5-carboxylic acid, 1 H-1,2,3-triazole, 3,5-diamino-1,2,4-triazole, 4-amino-3,5-di-2-pyridyl-4H-1,2,4-triazole, 1-trimethylsilyl-1,2,4-triazole, 5,6-dimethyl-1 H-benzotriazole, 6-chloro-1-hydroxybenzotriazole, 5-bromo-3-nitro-1,2,4-triazole, 1H-benzotriazole-1-methanol, 5-methyl-1H-1,2,4-triazole-3-thiol, 1-hydroxy-7-azabenzotriazole, 1-(trimethylsilyl)-1H-benzotriazole, 1-(methoxymethyl)-1H-benzotriazole, 5-phenyl-1 H-1,2,4-triazole-3-thiol, 4-amino-5-(4-pyridyl)-4H-1,2,4-triazole-3-thiol, 4-amino-5-phenyl-4H-1,2,4-triazole-3-thiol, 5-(4-pyridyl)-1 H-1,2,4-triazole-3-thiol, 1-(chloromethyl)-1 H-benzotriazole, 1H-benzotriazole-1-carboxaldehyde, 1-((phenylthio)methyl)-1H-benzotriazole, 1-propargyl-1 H-benzotriazole, N,N-dimethyl-1 H-benzotriazole-1-methan-amine, N-phenylbenzotriazolemethanamine, 1-(phenoxymethyl)-1H-benzotriazole, 1-(phenylsulfonyl)-1H-benzotriazole, (1-(4-morpholinyl)ethyl)benzotriazole, (4-morpholinylmethyl)benzotriazole, (1-pyrrolidinylmethyl)benzotriazole, 1H-benzotriazole-1-acetonitrile, 1-(1-ethoxy-2-propenyl)-1H-benzotriazole, (4-morpholinylphenylmethyl)benzotriazole, (1-(4-morpholinyl)propyl)benzotriazole, N,alpha-diphenylbenzotriazolemethan-amine, 1,1'-carbonylbisbenzotriazole, methyl-1 H-1,2,4-triazole-3-carboxylate, 2-(2-hydroxy-5-methylphenyl)benzotriazole, 1-trifluoromethylacetylbenzotriazole, 1-allylbenzotriazole, 1-hydroxy-6-(trifluoromethyl)benzotriazole, 1-methanesulfonyl-1 H-benzotriazole, 1-((trimethylsilyl)methyl)benzotriazole, 1-(2, 2, 2-trimethylacetyl)-1 H-benzotriazole, 1-(2-butenoyl)-1 H-benzotriazole, benzotriazole-1-carboxamide, 1-(4-chlorobenzoyl)-1H-benzotriazole, 1-(2-chloroacethylcarbonyl)-1H-benzotriazole, 1-(alpha-chloroacetyl)-1H-benzotriazole, 1-(1 H-indole-2-ylcarbonyl)-1H-benzotriazole, 1-(3-phenyl-2-propenoyl)-1H-benzotriazole, 1-(2-thienylcarbonyl)-1 H-benzotriazole, 1-(4-fluorobenzoyl)-1H-benzotriazole, 1-(2-furoyl)-1 H-benzotriazole, 1-(2-pyrrolecarbonyl)benzotriazole, 1-(4-pyridylcarbonyl)benzotriazole, 1-(2-pyridylcarbonyl)benzotriazole, 1-(1-naphthylcarbonyl)-1 H-benzotriazole, 4-hydroxy-1H-benzotriazole, 1 H-benzotriazole-4-sulfonic acid, benzotriazole-1-carbonyl chloride, 3-mercapto-4-methyl-4H-1,2,4-triazole, 1-(2-methylenesulfonyl)-1H-1,2,4-triazole, 1-(2- methylenesulfonyl)-3-nitro-1H-1,2,4-triazol, 1-(1-ethoxy-2-propynyl)-1H-benzotriazole, 1-(3-pyridinylsulfonyl)-1H-benzotriazole, 1-(2-pyridinylsulfonyl)-1H-benzotriazole, 1-(2-thienylsulfonyl)-1H-benzotriazole, 1,2,4-triazole-3-carboxylic acid, methyl 1 H-benzotriazole-1-carboxylate, 1-acetyl-1 H-benzotriazole, 3-nitro-1H-1,2,4-triazole, 1H-1,2,4-triazole-1-carboxamidine hydrochloride, 1,2,4-triazole, 1-vinyl-1,2,4-triazole, benzotriazole, 5-chlorobenzotriazole, 1,1'-carbonyldi(1,2,4-triazole), 5,6-dimethyl-1H-benzotriazole hydrate, aminotriazole, 1-methyl-1H-benzotriazole, 5-amino-4H-(1,2,4)triazole-3-carboxylic acid, 2-(2-aminophenyl)-1 H-1,3,4-triazole, or 5-anilino-4H-1,2,4-triazole-3-thiol.

The amount of the compound containing a triazole group may be in the range of 0.05 - 2.0 parts by weight based on 100 parts by weight of the coating composition for an interconnection part of an electrode according to the current embodiment of the present invention. When the amount of the compound containing a triazole group is less than 0.05 parts by weight, such anti-migration property cannot be obtained. On the other hand, when the amount of the compound containing a triazole group is greater than 2.0 parts by weight based on 100 parts by weight of the coating composition for an interconnection part of an electrode, the compound containing a triazole group may not be mono-dispersed when mixed with other constituent compounds to prepare the coating composition for an interconnection part of an electrode according to the current embodiment of the present invention.

The present invention also provides a plasma display panel (PDP) including the coating composition for an interconnection part of an electrode as described above. In particular, the plasma display panel according to an embodiment of the present invention includes a panel display unit including a plurality of electrodes and a panel interconnection unit providing a driving signal to the electrodes. The panel interconnection unit includes electrode pads connected to the electrodes of the panel display unit, and a film-shaped device which is connected to the electrode pads and provides a driving signal, wherein the coating composition for an interconnection part of an electrode according to an embodiment of the present invention is coated on the electrode pads. The coating composition for an interconnection part of an electrode according to an embodiment of the present invention may form a blocking layer such that the exposed surface of the electrode pads between the panel display unit or film-shaped device and the electrode pads is isolated from the outside. In particular, the coating composition for an interconnection part of an electrode according to an embodiment of the present invention may be completely coated on the electrode pads. The thickness of the blocking layer formed of the coating composition for an interconnection part of an electrode according to an embodiment of the present invention is not limited when the surface of the electrode pads is completely sealed. For example, the thickness of the blocking layer may be about 0.5 µm to obtain a high yield.

FIG. 7 is a sectional view of a plasma display panel including an interconnection unit according to an embodiment of the present invention.

Referring to FIG. 7, the plasma display panel according to the current embodiment of the present invention includes a panel display unit D'1 including a plurality of electrodes, in which an image is displayed, and a panel interconnection unit D'2 providing a driving signal to the electrodes of the panel display unit D'1.

Like a conventional plasma display panel, the panel display unit D'1 includes a top panel 10A', a bottom panel 10B', and a sealing agent 12' which combines the top panel 10A' with the bottom panel 10B' to form a discharge cell.

The top panel 10A' includes a transparent electrode 2' constituting a scan electrode or a sustain electrode disposed parallel to the scan electrode on a top glass layer 1A', a metal bus electrode 3' formed on an end of the transparent electrode 2', a metal bus electrode pad 11' extending from the metal bus electrode 3' to the panel interconnection unit D'2 and an upper dielectric layer 4' and a protecting layer 5', which cover the transparent electrode 2', the metal bus electrode 3' and the metal bus electrode pad 11' and are sequentially deposited on the top glass layer 1 A'. The metal bus electrode 3' may be formed of Ag which has excellent electric conductivity, and the metal bus electrode pad 11' connected to the metal bus electrode 3' can be also formed of Ag.

The bottom panel 10B' includes an address electrode (not shown) disposed perpendicular to a scan electrode or sustain electrode on a bottom glass layer (not shown), and a lower dielectric layer (not shown) covering the address electrode on the bottom glass layer (not shown.)

The panel interconnection unit D'2 includes a metal bus electrode pad 11'. The metal bus electrode pad 11' extends from the panel display unit D'1 on the top glass layer 1A', and a film-shaped device 14' is connected to the metal bus electrode pad 11' and provides a driving signal controlled by a printed circuit board (PCB). The film-shaped device 14' can be a chip on flexible printed circuit (COF) or a tape carrier package (TCP.) The electrode pad 11' may be adhered to the film-shaped device 14' by an anisotropic conductive film (ACF) 16'. The ACF 16' may have a film shape prepared by dispersing a metal-coated epoxy or metal particles, and electrically connecting the metal bus electrode pad 11' electrically connected to the metal bus electrode 3' to the film-shaped device 14'.

A coating composition for an interconnection part of an electrode 13 as described above is coated on the panel interconnection unit D'2 of the plasma display panel according to the current embodiment of the present invention. The metal bus electrode pad 11' of the panel interconnection unit D'2 has a first area exposed (i.e., not covered) by the film-shaped device 14' and a second area covered by the film-shaped device 14'. The coating composition for an interconnection part of an electrode 13 is coated on the first area of the metal bus electrode pad 11'. The coating composition for an interconnection part of an electrode 13 can be coated before the ACF 16' is compressed ( "formed") on the metal bus electrode pad 11'.

A plasma display panel according to an embodiment of the present invention has excellent resistance to gases and humidity in the surrounding environment and anti-migration properties compared to a conventional plasma display panel by coating a coating composition for an interconnection part of an electrode on a panel interconnection unit.

The present invention will be described in further detail with reference to the following examples. These examples are for illustrative purposes only and are not intended to limit the scope of the present invention.

### Example 1: Manufacturing of Coating Composition for Interconnection Part of Electrode

3.5 parts by weight of a silane-based compound, 0.5 parts by weight of an anatase type titanium oxide, and 0.05 parts by weight of 1,2,4-triazole, were mixed with a deionized water solvent, heated at 40~80°C in a hot water bath, and then stirred at 200 rpm for one hour, to prepare a 1% deionized water solution. Specifically, 0.05 parts by weight of 1,2,4-triazole was mixed with SE 9189 L-SP of Korea Dow Corning Co., Ltd to prepare a coating composition for an interconnection part of an electrode.

### Example 2: Manufacturing of Coating Composition for Interconnection Part of Electrode

A coating composition for an interconnection part of an electrode was prepared as described in Example 1, except that 1.0 parts by weight of an anatase type titanium oxide was used.

### Example 3: Manufacturing of Coating Composition for Interconnection Part of Electrode

A coating composition for an interconnection part of an electrode was prepared as described in Example 1, except that 1.5 parts by weight of an anatase type titanium oxide was used.

### Experiment Example 1: Manufacturing of Plasma Display Panel

The coating composition for an interconnection part of an electrode prepared according to Example 1 was coated on an electrode pad exposed (i.e., not covered) by an upper dielectric layer and a film-shaped device to a thickness of 0.5µm before an ACF was compressed (formed).

### Experiment Example 2: Manufacturing of Plasma Display Panel

The coating composition for an interconnection part of an electrode prepared according to Example 2 was coated on an electrode pad exposed (i.e., not covered) by an upper dielectric layer and a film-shaped device to a thickness of 0.5µm before an ACF was compressed (formed).

### Experiment Example 3: Manufacturing of Plasma Display Panel

The coating composition for an interconnection part of an electrode prepared according to Example 3 was coated on an electrode pad exposed (i.e., not covered) by an upper dielectric layer and a film-shaped device to a thickness of 0.5µm before an ACF was compressed (formed).

### Comparative Example 1

A conventional plasma display panel in which the coating composition for an interconnection part of an electrode of Example 1 was not used was also manufactured.

### Comparative Example 2

A plasma display panel was manufactured as described in Experiment Example 1, except that the compound containing a triazole group was not used.

### Performance Tests

1) Identification using Scanning Electron Microscopy (SEM)

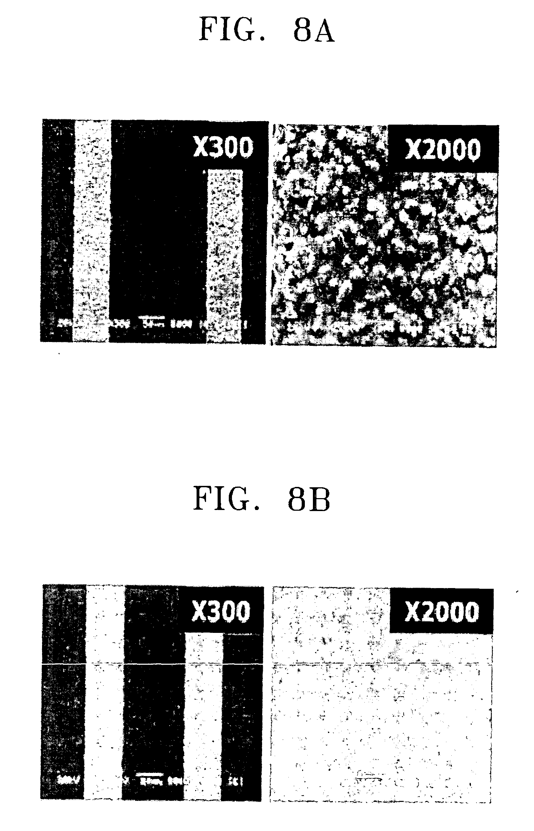

FIG. 8A is a SEM image of an interconnection unit on which a coating composition for an interconnection part of an electrode according to an embodiment of the present invention was not coated, that is an interconnection part of an electrode of conventional plasma display panel. , Furthermore, FIG. 8B is a SEM image of an interconnection unit on which a coating composition for an interconnection part of an electrode according to an embodiment of the present invention was coated. Referring to FIGS. 8A and 8B, it can be seen that a thin layer is formed on the surface of the interconnection part of an electrode of a plasma display panel according to an embodiment of the present invention, and the diffusion between electrodes was significantly decreased in the plasma display panel according to an embodiment of the present invention compared to a conventional plasma display panel.

### 2) High Temperature/High Humidity Reliability Tests

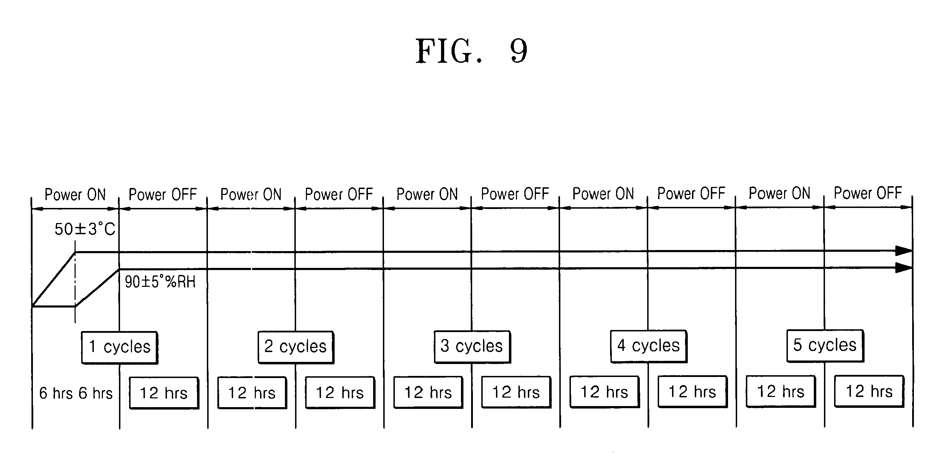

High temperature/high humidity reliability tests were performed using the plasma display panels of Comparative Examples 1 and 2, and plasma display panels of Experiment Examples 1, 2 and 3. Specifically, the high temperature/high humidity reliability test was performed using 25 samples, five for each sample, under high temperature/high humidity reliability test conditions shown in FIG. 9. The conditions shown in FIG. 9 are set on the basis of the amount of saturated vapor accumulated when a plasma display panel operates for 60000 hours at 25°C in a relative humidity of 50%. To reach the amount of the saturated vapor described above, the samples were tested at 50°C, in the relative humidity of 90%, for 5 days.

Test results showing the number of defects according to the number of cycles are shown in Table 1.

**Table 1**

| No. of Samples | Test Result Data | | | | | Sample |
|---|---|---|---|---|---|---|
| | 1 cycle | 2 cycles | 3 cycles | 4 cycles | 5 cycles | |
| 5 | 0 | 0 | 0 | 2 | 4 | Comparative Example 1 |
| 5 | 0 | 0 | 0 | 1 | 1 | Comparative Example 2 |
| 5 | 0 | 0 | 0 | 0 | 0 | Experiment Example 1 |
| 5 | 0 | 0 | 0 | 0 | 0 | Experiment Example 2 |
| 5 | | 0 | 0 | 0 | 0 | Experiment Example 3 |

As shown in Table 1, the plasma display panels in which the coating composition for an interconnection part of an electrode was used had no defects even when the number of cycles increased. On the other hand, although the plasma display panel prepared according to Comparative Example 1 or Comparative Example 2 had no defects at the beginning, the number of defects gradually increased as the number of cycles increased.

### 3) Data Normality Test and Test for Equal Variances

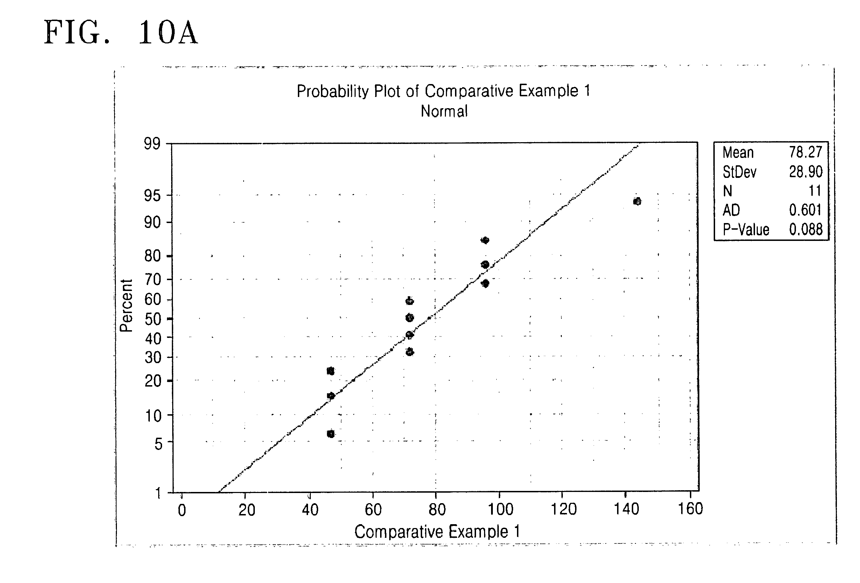

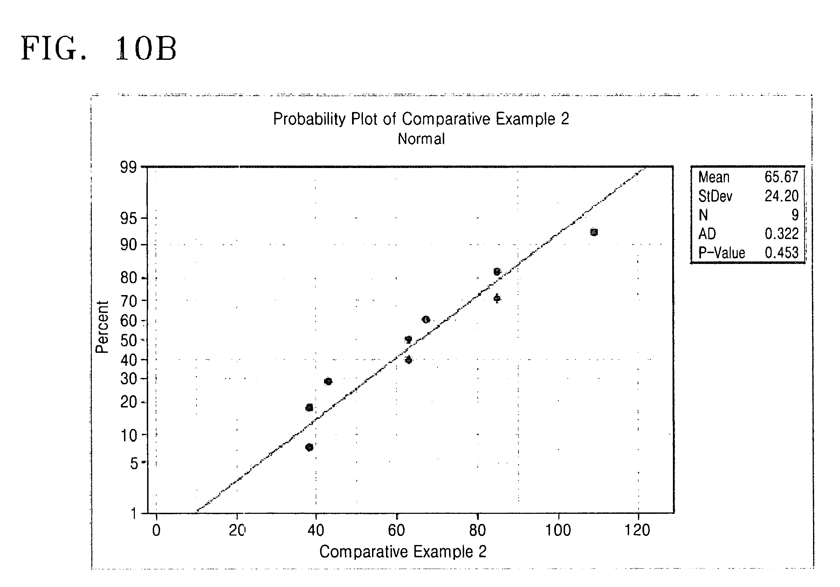

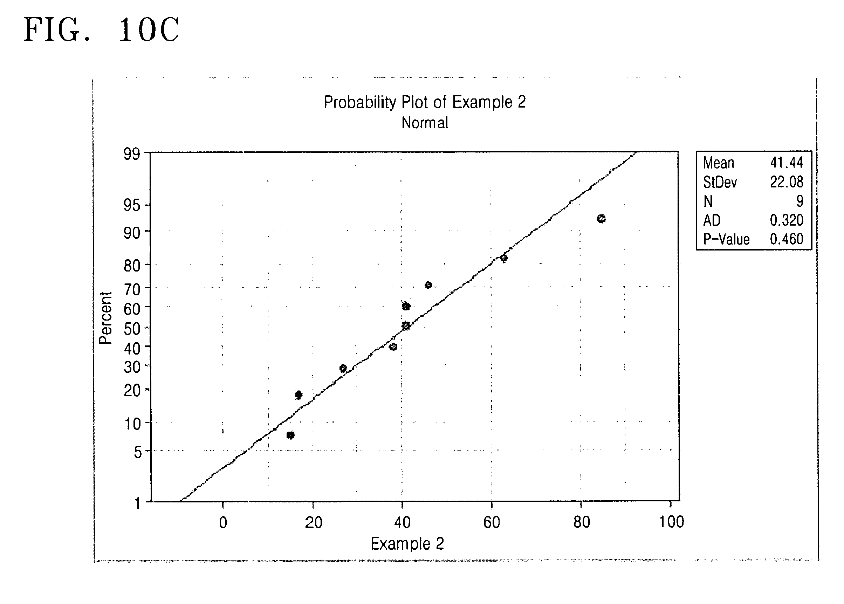

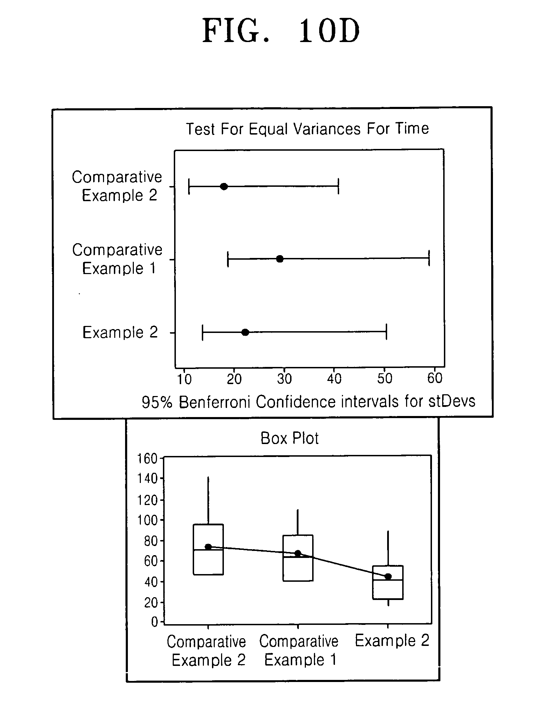

A data normality test and a test for equal variances were performed using the test results of Table 1. FIGS. 10A through 10D are graphs illustrating results of the data normality test and the test for equal variances. Referring to FIGS. 10A through 10D, a p-value was 0.46, which indicates significance. Accordingly, it can be seen that the coating composition for an interconnection part of an electrode according to an embodiment of the present invention is very effective for reducing the number of opens and short circuits in electrodes of a plasma display panel.

The present invention provides a coating composition for an interconnection part of an electrode, which effectively prevents opens and short circuits of an electrode due to damage of an interconnection unit caused by gases and humidity in the surrounding environment and due to a migration phenomenon, and a plasma display panel including the coating composition.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A coating composition for an interconnection part of an electrode, comprising:
0.05 to 2.0 parts by weight of a compound containing a triazole group;
3.5 to 7.5 parts by weight of a silane-based compound; and
0.5 to 2.0 parts by weight of a transition metal oxide.

2. A coating composition according to claim 1, wherein the compound containing the triazole group is a compound having an anti-migration property.

3. A coating composition according to claim 1 or 2, wherein the silane-based compound is a compound capable of acting as an adhesive or a sealant.

4. A coating composition according to any one of claims 1 to 3, wherein the transition metal oxide is titanium oxide.

5. A coating composition according to any one of claims 1 to 4, wherein the silane-based compound is alkoxy siloxane, dimethyl siloxane, methyltrimethoxy silane, or a blend thereof.

6. A coating composition according to any one of claims 1 to 4, wherein the silane-based compound is represented by Formula 1: 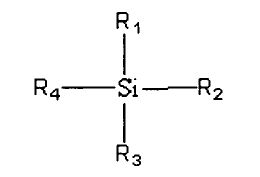 wherein R_{1'} R_{2'} R₃ and R₄ are each independently one of H, an alkyl group, a vinyl group, a silane group, an alkylhalide group, a halide group, an aryl group, an alkoxy group, an ether group, an epoxide group, an alcohol group, an ester group, an amine group, an acid group, a nitrile group and an isocyanate group.

7. A coating composition according to any one of claims 1 to 4, wherein the silane-based compound is at least one selected from the group consisting of tripropylsilane, triisopropylsilane, tributylsilane, triisobutylsilane, trihexylsilane, dimethyloctadecylsilane, tetraethylsilane, diisopropyloctylsilane, triethylvinylsilane, allyltrimethylsilane, allyltriisopropylsilane, trimethyl(3-methyl-2-butyl)-silane, diallyldimethylsilane, tetravinylsilane, tetraallylsilane, triphenylvinylsilane, allyltriphenylsilane, bis(trimethylsilyl)methane, tris(trimethyisilyl)methane, hexamethyldisilane, tetrakis(trimethylsilyl)silane, bis(chloromethyl)dimethylsilane, chlorodiisopropylsilane, 1,2-bis(chlorodimethylsilyl)ethane, chlorotriethylsilane, chlorodimethyloctylsilane, dimethylphenylsilane, 1,2-bis(dimethylsilyl)benzene, 1,4-bis(dimethylsilyl)benzene, phenyltrimethylsilane, diphenylsilane, diphenylmethylsilane, triphenylsilane, tribenzylsilane, benzyltrimethylsilane, benzyloxytrimethylsilane, (methoxymethyl)trimethylsilane, ethoxytrimethylsilane, propoxytrimethylsilane, methoxydimethyloctylsilane, methoxydimethyloctadecylsilane, dimethoxymethyloctylsilane, trimethoxypropylsilane, isobutyltrimethoxysilane, octyltrimethoxysilane, octadecyltrimethoxysilane, methyltrimethoxysilane, ethyltrimethoxysilane, isobutyltriethoxysilane, octyltriethoxysilane, diethoxyphenylsilane, phenyltrimethoxysilane, phenyltriethoxysilane, vinyltrimethoxysilane, triethoxyvinylsilane, allyltriethoxysilane, tris(2-methoxyethoxy)vinylsilane, 3-glycidoxypropyltrimethoxysilane, diethoxy(3-glycidyloxypropyl)methylsilane, trimethoxy[2-(7-oxabicyclo[4.1.0]hept-3-yl)ethyl]silane, (trimethylsilyl)methanol, 1-(trimethylsilyl)ethanol, 2-(trimethylsilyl)ethanol, 3-(trimethylsilyl)-1-propanoltriethylsilanol, t-butyldimethylsilanol, 5-(t-butyldimethylsilyloxy)-1-pentanol, 2-(methyldiphenylsilyl)ethanol, trimethylsilylacetate, trimethylsilylmethylacetate, methyl(trimethylsilyl)acetate, ethyl(trimethylsilyl)acetate, t-butyl(trimethylsilyl)acetate, ethyl 3-(trimethylsilyl)-propionate, 2-[(trimethylsilyl)methyl]-2-propen-1-yl acetate, trimethylsilyl methacrylate, 2-(trimethylsilyloxy)ethyl methacrylate, 3-(trimethoxysilyl)propyl methacrylate, methyltrimethylsilylmalonate, ethyltrimethylsilylmalonate, bis(trimethylsilyl)malonate, N,N-diethyl(trimethylsilylmethyl)amine, N-t-butyltrimethylsilylamine, N,N-diethyltrimethylsilylamine, 1,1'-ethylenebis(N,N,1,1-tetramethyl)silaneamine, 1-(trimethylsilyl)pyrrolidine, 4-(trimethylsilyl)morpholine, (trimethylsilyl)acetic acid, 3-(trimethylsilyl)propionic acid, 3-(triethoxysilyl)propionitrile, t-butyldiphenylsilylcyanide, and 3-(triethoxysilyl)propyl isocyanate.

8. A coating composition according to any one of claims 1 to 7, wherein the transition metal oxide is a mineral form of the transition metal oxide selected from the group consisting of rutile, anatase and brookite.

9. A coating composition according to any one of claims 1 to 8, wherein the compound containing the triazole group is at least one selected from the group consisting of 1-aminobenzotriazole, 3-amino-1,2,4-triazole-5-thiol, 3-amino-1,2,4-triazole, 4-amino-4H-1,2,4-triazole, 1-hydroxybenzotriazole, 1 H-1,2,4-triazole-3-thiol, 1 H-benzotriazole, 1-(benzyloxycarbonyl)benzotriazole, 3-amino 5-mercapto-1,2,4-triazole, 5-anilino-1,2,3,4-thiatriazole, 3-amino-5-methylthio-1H-1,2,4-triazole, 5-methyl-1 H-benzotriazole, 1,1'-carbonyl-di-(1,2,4-triazole), 1-(2-mesitylenesulfonyl)-1,2,4-triazole, 1-(2-mesitylenesulfonyl)-3-nitro-1,2,4-triazole, 3-nitro-1,2,4-triazole, 4-methyl-4H-1,2,4-triazole-3-thiol, 1,2,3-triazole-4,5-dicarboxylic acid, 3-nitro-1-(8-quinolylsulfonyl)-1H-1,2,4-triazole, benzotriazole-5-carboxylic acid, 1 H-1,2,3-triazole, 3,5-diamino-1,2,4-triazole, 4-amino-3,5-di-2-pyridyl-4H-1,2,4-triazole, 1-trimethylsilyl-1,2,4-triazole, 5,6-dimethyl-1 H-benzotriazole, 6-chloro-1-hydroxybenzotriazole, 5-bromo-3-nitro-1,2,4-triazole, 1H-benzotriazole-1-methanol, 5-methyl-1H-1,2,4-triazole-3-thiol, 1-hydroxy-7-azabenzotriazole, 1-(trimethylsilyl)-1H-benzotriazole, 1-(methoxymethyl)-1H-benzotriazole, 5-phenyl-1 H-1,2,4-triazole-3-thiol, 4-amino-5-(4-pyridyl)-4H-1,2,4-triazole-3-thiol, 4-amino-5-phenyl-4H-1,2,4-triazole-3-thiol, 5-(4-pyridyl)-1H-1,2,4-triazole-3-thiol, 1-(chloromethyl)-1 H-benzotriazole, 1H-benzotriazole-1-carboxaldehyde, 1-((phenylthio)methyl)-1H-benzotriazole, 1-propargyl-1H-benzotriazole, N,N-dimethyl-1H-benzotriazole-1-methan-amine, N-phenylbenzotriazolemethanamine, 1-(phenoxymethyl)-1H-benzotriazole, 1-(phenylsulfonyl)-1H-benzotriazole, (1-(4-morpholinyl)ethyl)benzotriazole, (4-morpholinylmethyl)benzotriazole, (1-pyrrolidinylmethyl)benzotriazole, 1H-benzotriazole-1-acetonitrile, 1-(1-ethoxy-2-propenyl)-1H-benzotriazole, (4-morpholinylphenylmethyl)benzotriazole, (1-(4-morpholinyl)propyl)benzotriazole, N,alpha-diphenylbenzotriazolemethan-amine, 1,1'-carbonylbisbenzotriazole, methyl-1 H-1,2,4-triazole-3-carboxylate, 2-(2-hydroxy-5-methylphenyl)benzotriazole, 1-trifluoromethylacetylbenzotriazole, 1-allylbenzotriazole, 1-hydroxy-6-(trifluoromethyl)benzotriazole, 1-methanesulfonyl-1 H-benzotriazole, 1-((trimethylsilyl)methyl)benzotriazole, 1-(2, 2, 2-trimethylacetyl)-1H-benzotriazole, 1-(2-butenoyl)-1H-benzotriazole, benzotriazole-1-carboxamide, 1-(4-chlorobenzoyl)-1H-benzotriazole, 1-(2-chloroacethylcarbonyl)-1 H-benzotriazole, 1-(alpha-chloroacetyl)-1H-benzotriazole, 1-(1 H-indole-2-ylcarbonyl)-1 H-benzotriazole, 1-(3-phenyl-2-propenoyl)-1 H-benzotriazole, 1-(2-thienylcarbonyl)-1 H-benzotriazole, 1-(4-fluorobenzoyl)-1 H-benzotriazole, 1-(2-furoyl)-1 H-benzotriazole, 1-(2-pyrrolecarbonyl)benzotriazole, 1-(4-pyridylcarbonyl)benzotriazole, 1-(2-pyridylcarbonyl)benzotriazole, 1-(1-naphthylcarbonyl)-1 H-benzotriazole, 4-hydroxy-1H-benzotriazole, 1H-benzotriazole-4-sulfonic acid, benzotriazole-1-carbonyl chloride, 3-mercapto-4-methyl-4H-1,2,4-triazole, 1-(2-methylenesulfonyl)-1H-1,2,4-triazole, 1-(2-methylenesulfonyl)-3-nitro-1H-1,2,4-triazol, 1-(1-ethoxy-2-propynyl)-1H-benzotriazole, 1-(3-pyridinylsulfonyl)-1H-benzotriazole, 1-(2-pyridinylsulfonyl)-1H-benzotriazole, 1-(2-thienylsulfonyl)-1H-benzotriazole, 1,2,4-triazole-3-carboxylic acid, methyl 1 H-benzotriazole-1-carboxylate, 1-acetyl-1 H-benzotriazole, 3-nitro-1H-1,2,4-triazole, 1H-1,2,4-triazole-1-carboxamidine hydrochloride, 1,2,4-triazole, 1-vinyl-1,2,4-triazole, benzotriazole, 5-chlorobenzotriazole, 1,1'-carbonyldi(1,2,4-triazole), 5,6-dimethyl-1H-benzotriazole hydrate, aminotriazole, 1-methyl-1H-benzotriazole, 5-amino-4H-(1,2,4)triazole-3-carboxylic acid, 2-(2-aminophenyl)-1H-1,3,4-triazole, or 5-anilino-4H-1,2,4-triazole-3-thiol.

10. A plasma display panel (PDP), comprising:
a panel display unit comprising a plurality of electrodes; and
a panel interconnection unit providing a driving signal to the plurality of the electrodes, the panel interconnection unit comprising:
electrode pads connected to the electrodes of the panel display unit;
a coating composition coated on at least a part of the electrode pads, the coating composition being according to any one of claims 1 to 9; and
a film-shaped device electrically connected to the electrode pads.

11. A plasma display panel according to claim 10, wherein each of the electrode pads has a first area which is not covered by the film-shaped device and on which the coating composition is coated, and a second area which is covered by the film-shaped device.

12. A plasma display panel according to claim 10 or 11, wherein the electrode pads comprise Ag.

13. A plasma display panel (PDP), comprising:
a first substrate;
a second substrate facing the first substrate, with a plurality of discharge cells filled with a discharge gas between the first substrate and the second substrate;
a plurality of display electrodes formed on the first substrate opposing to the second substrate, each of said plurality of display electrodes comprising a pair of a transparent electrode formed on the first substrate and a bus electrode formed on a surface of the transparent electrode;
bus electrode pads extending from the bus electrodes to the outside of the discharge cells, the bus-electrode pads coated with a coating composition being according to any one of claims 1 to 9; and
the film-shaped device electrically connected to the bus electrode pad to provide a driving signal.

14. A plasma display panel according to claim 13, wherein each of the bus electrode pads has a first area which is not covered by the film-shaped device and on which the coating composition is coated, and a second area which is connected to the film-shaped device.

15. A plasma display panel according to claim 13 or 14, wherein the electrode pads comprise Ag.
